(19) **Europäisches Patentamt**

**European Patent Office**

**Office européen des brevets**

(11) **EP 1 696 003 A1**

(12) **EUROPEAN PATENT APPLICATION**
published in accordance with Art. 158(3) EPC

(43) Date of publication:
**30.08.2006 Bulletin 2006/35**

(51) Int Cl.:
*C08L 101/00* (2006.01)  *C08K 3/00* (2006.01)
*C08K 3/34* (2006.01)  *H05K 1/03* (2006.01)

(21) Application number: **04806984.3**

(22) Date of filing: **14.12.2004**

(86) International application number:
**PCT/JP2004/018623**

(87) International publication number:
**WO 2005/056684 (23.06.2005 Gazette 2005/25)**

(84) Designated Contracting States:
**DE FR GB**

(30) Priority: **15.12.2003 JP 2003417175**

(71) Applicant: **SEKISUI CHEMICAL CO., LTD.**
**Osaka-shi,**
**Osaka 530-8565 (JP)**

(72) Inventors:
 • **SHIBAYAMA, Koichi,**
 **c/o SEKISUI CHEMICAL CO., LTD**
 **Mishima-gun,**
 **Osaka 618-8589 (JP)**

 • **YONEZAWA, Koji,**
 **c/o SEKISUI CHEMICAL CO., LTD**
 **Mishima-gun,**
 **Osaka 618-8589 (JP)**

(74) Representative: **Merkle, Gebhard**
 **TER MEER STEINMEISTER & PARTNER GbR,**
 **Patentanwälte,**
 **Mauerkircherstrasse 45**
 **81679 München (DE)**

(54) **THERMOPLASTIC RESIN COMPOSITION, MATERIAL FOR SUBSTRATE AND FILM FOR SUBSTRATE**

(57)  Disclosed is a thermoplastic resin composition which enables to obtain a molded article that is capable of maintaining the molded shape even when the article is heated after molding and is excellent in dimensional stability and heat resistance. The thermoplastic resin composition contains 100 parts by weight of a thermoplastic resin and 0.1 - 100 parts by weight of an inorganic compound dispersed in the thermoplastic resin. Not less than 75 % of the molded shape of an article can be maintained even after the article is heated to a temperature not less than the glass transition temperature or melting point of the thermoplastic resin. Also disclosed are a material and a film for substrates composed by using such a thermoplastic resin composition.

**EP 1 696 003 A1**

**Description**

**TECHNICAL FIELD**

The present invention relates to a thermoplastic resin composition which maintain the shape of a molded article even at elevated temperatures and more specif icallyto a thermoplastic resin composition which contains a thermoplastic resin and an inorganic compound and is excellent in heat resistance after molding, and a material for substrates and a film for substrates composed by using such a thermoplastic resin composition.

**BACKGROUND ART**

In recent years, electronic equipment has been sophisticated, become multifunctional and become smaller in size, rapidly, and in electronic parts used in electronic equipment, requests for a downsizing and a weight reduction are enhanced. With the downsizing and the weight reduction of the electronic parts, materials of the electronic parts are required to further improve properties such as heat resistance, mechanical strength, electrical properties and the like. For example, as for apackage of a semiconductor device or a wiring board on which a semiconductor device is surface mounted, a substance having a higher density, multifunction and high-performance is required.

A multi-layer printed-circuit board used in electronic equipment is composed of a plurality of layered insulating substrates. Hitherto, as these interlayer insulating substrates, there have been used, for example, thermosetting resin prepreg prepared by impregnating glass cloth with a thermosetting resin or a film composed of a thermosetting resin or a photo-curable resin. Also in the multi-layer printed-circuit board, it is desired to make an interlayer portion extremely thin in order to realize a high-density and low-profile printed-circuit board, and an interlayer insulating substrate using thin glass cloth or an interlayer not using glass cloth is required. As such an interlayer insulating substrate, there are known, for example, insulating substrates composed of (1) rubbers (elastomers), (2) thermosetting resin materials modified with acrylic resin or the like, and (3) thermoplastic resin materials mixed with a large amount of an inorganic filler.

In Japanese Unexamined Patent Publications No.2000-183539, there is disclosed a method of fabricating a multilayer insulating substrate, in which an inorganic filler having a predetermined particle diameter is mixed in varnish which is predominantly composed of an epoxy polymer having a high molecular weight and a polyfunctional epoxy resin and the resulting mixture is applied to a supporting body to form an insulating layer.

Generally, in thermoplastic resins and photo-curable resins, curing by heat or light was required after molding. Therefore, since a curing step had to be performed, productivity can do nothing but became low. On the other hand, when a thermoplastic resin is heated to temperatures close to the glass transition point Tg or the melting point of this thermoplastic resin, the resin begins softening at a temperature lower than the glass transition point or the melting point by from 20°C to 40°C and deformation and fluidization of resin take place. Therefore, it is necessary in the thermoplastic resin that the glass transition point Tg or the melting point is a required heat resisting temperature of a product using this thermoplastic resin or higher. Thus, generally, engineering plastics having a high glass transition point or melting point are used as a thermoplastic resin.

A method of mixing an inorganic compound into the thermoplastic resin inorder to enhance the dimensional stability and the mechanical properties of the thermoplastic resin is commonly known. However, for enhancing the ability to maintain a shape at elevated temperatures, it was necessary to charge a large amount of the inorganic compound so that the inorganic compound makes up 50% or more of the whole thermoplastic resin composition, or to crosslink a large amount of the inorganic compound.

Further, inrecentyears, there are pursued the development aimed at adopting optoelectronics in electronic devices and communications devices. The issues in the present state of affairs in such high polymer materials for optical communications is to be low in loss, to be excellent in heat resistance, to have a low thermal and linear expansion coefficients, to be excellent in resistance to excess moisture and to be capable of controlling a refractive property. Herein, that it is low in loss in a material for optical communications means that the material itself does not have an optical absorption band in a wavelength range to be used for optical communication.

As a material for optical communications, there is disclosed a replicated polymeric optical waveguide in "Replicated Polymeric Optical Waveguide" Electronic Materials No.12 (2002), p.27-30. In this reference, a die (stamper) patterned after a desired core pattern is pressed against a photo-curable resin, and then the core pattern is transferred by UV irradiation. For example, when a similar processing technique was applied to a thermoplastic resin, there was a problem that if the die (stamper) is pressed against the thermoplastic resin in a state of being heated to elevated temperatures and softened and then the die is peeled off from the thermoplastic resin in a state of relatively high temperature without being adequately cooled, a shape of the molded resin cannot be maintained because of the deformation of resin, or a patterned portion is left in the die.

Accordingly, it is strongly desired in the thermoplastic material that the thermoplastic resin is not only excellent in properties such as a low linear expansion coefficient and a low hygroscopicity but also excellent in a releasing property and heat resistance after molding in order to shorten the cycle of production. Further, when the thermoplastic material is used as a material for optical communications, transparency is also required in addition to these characteristics.

## DISCLOSURE OF THE INVENTION

It is an object of the present invention to provide a thermoplastic resin composition which enables to obtain a molded article that is excellent in mechanical properties of being capable of maintaining the shape of a molded article even when the article is heated after molding, dimensional stability and heat resistance, and particularly excellent in the ability to micro mold and properties at elevated temperature, and a material for substrates and a film for substrates composed by using such a thermoplastic resin composition.

A thermoplastic resin composition concerning the first present invention contains 100 parts by weight of an amorphous thermoplastic resin and 0.1 to 100 parts by weight of an inorganic compound dispersed in the above-mentioned thermoplastic resin and is characterized in that not less than 75% of the shape of a molded article is maintained at temperatures above the glass transition point of the thermoplastic resin.

A thermoplastic resin composition concerning the second present invention contains 100 parts by weight of a crystalline thermoplastic resin and 0.1 to 100 parts by weight of an inorganic compound dispersed in the above-mentioned thermoplastic resin and is characterized in that not less than 75% of the shape of a molded article is maintained at temperatures above the melting point of the thermoplastic resin.

In the present invention (the first present invention and the second present invention), the dispersion particle diameter of the above-mentioned inorganic compound is preferably 2 $\mu$m or less.

And, the above inorganic compound preferably has silicon and oxygen as a constituent element, and the above inorganic compound is more preferably laminar silicate.

A material for substrates and a film for substrates concerning the present invention are characterized by being composed by using the thermoplastic resin composition of the present invention.

The thermoplastic resin composition concerning the first present invention is excellent in heat resistance since an inorganic compound is mixed in the thermoplastic resin composition in an amount 0.1 to 100 parts by weight with respect to 100 parts by weight of an amorphous thermoplastic resin and not less than 75% of the shape of a molded article is maintained even at a temperature of the glass transition point minus 20°C or higher.

Generally, in the amorphous thermoplastic resin, when the amorphous thermoplastic resin is heated to temperatures close to the glass transition point Tg, the fluidity of the resin rapidly increases. Accordingly, the molding by heating itself is relatively easy. On the other hand, the dimensional stability and the ability to maintain a shape after molding are rapidly deteriorated when the amorphous thermoplastic resin is heated to temperatures close to the glass transition point Tg.

However, in the thermoplastic resin composition concerning the present invention, the inorganic compound is mixed in the thermoplastic resin composition in an amount 0.1 to 100 parts by weight with respect to 100 parts by weight of the above amorphous thermoplastic resin and not less than 75% of the shape of a molded article is maintained even at a temperature of the glass transition point minus 20°C or higher. That is, the fluidity of resin after molding is constrained and the ability to maintain a shape and dimensional stability at elevated temperature are effectively enhanced.

Similarly, the thermoplastic resin composition concerning the second present invention is excellent in the heat resistance of a molded article since an inorganic compound is mixed in the thermoplastic resin composition in an amount 0.1 to 100 parts by weight with respect to 100 parts by weight of a crystalline thermoplastic resin and not less than 75% of the shape of a molded article is maintained even at a temperature of the melting point minus 20°C or higher. And, since the fluidity of resin after molding is constrained, the dimensional stability and the ability to maintain a shape of the molded article at elevated temperature are effectively enhanced.

In the present invention, when the dispersion particle diameter of the above inorganic compound is 2 $\mu$m or less, an interface area between the thermoplastic resin and the inorganic compound becomes large and therefore viscosity of the resin composition at elevated temperature increases. Accordingly, the ability to maintain a shape of a molded article is more effectively enhanced.

When laminar silicate is used as the above inorganic compound, not only a rate of maintaining a shape is effectively enhanced, but also a molded article having excellent heat insulation and heat resistance can be attained.

The material for substrates and the film for substrates concerning the present invention are composed by using the thermoplastic resin composition concerning the present invention. Accordingly, not only properties, dimensional accuracy and heat resistance of the material for substrates and the film for substrates are enhanced, but also the material for substrates and the film for substrates, having various shapes, can be obtained with high accuracy by thermoforming.

## BRIEF DESCRIPTION OF THE DRAWINGS

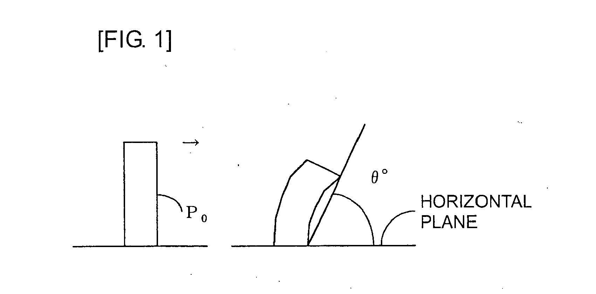

Figure 1 is a view illustrating a method of evaluating a self-supporting property after molding as one of evaluations of the ability to maintain a shape in Examples and Comparative Examples.

**BEST MODE FOR CARRYING OUT THE INVENTION**

Hereinafter, the specific aspects for carrying out the present invention will be described to clarify the present invention.

When a thermoplastic resin composition of the present invention is used, squeeze and bleed of resin and cracks of a molded article, which are associated with a rapid change in temperature or in pressure in usual thermoforming of a thermoplastic resin composition, hardly take place.

Incidentally, usual thermoforming includes widely, for example, injection molding, compression molding, hot-melt extrusion, heat laminating, and SMC (sheet molding compound) molding.

Generally, in thermoforming, when a thermoplastic resin like polyolefin resin or acrylic resin is heated to temperatures close to the glass transition point Tg in the case of amorphous resin and heated to temperatures close to the melting point in the case of crystalline resin, the fluidity of the resin rapidly increases. Accordingly, the molding by heating is relatively easy.

On the other hand, the dimensional stability and the ability to maintain a shape after molding are rapidly deteriorated when the thermoplastic resin is heated to temperatures close to its glass transition point Tg or melting point. However, when the thermoplastic resin composition concerning the present invention is used, the fluidity of resin is constrained after molding and therefore dimensional stability and the ability to maintain a shape at elevated temperature can be effectively enhanced.

A thermoplastic resin composition concerning the present invention contains 100 parts by weight of an amorphous or crystalline thermoplastic resin composition and 0.1 to 100 parts by weight of an inorganic compound and not less than 75% of the shape of a molded article is maintained even after the article is heated to a temperature of the glass transition point Tg minus 20°C or higher in the amorphous thermoplastic resin and a temperature of the melting point minus 20°C or higher in the crystalline thermoplastic resin after molding.

When a height of an article molded into the form of a cylinder is denoted by H and a diameter of the article is denoted by D, a rate of maintaining a shape, which is represented as not less than 75% described above, can be determined from the ratio between H/D values measured before and after temperature raising. For example, when a resin is molded into a shape in which H/D is equal to 2 before temperature raising, the rate of maintaining a shape is 75% or more if H/D is 1.5 or more after temperature raising.

Further, in the present invention, a method of molding the thermoplastic resin composition is not particularly limited and the thermoplastic resin composition is molded by an appropriate method such as pressing and compression.

If a resin has the rate of maintaining a shape of 75% or more, an environmental range within which the resin can be used is increased even when the resin is a general-purpose resin having relatively low heat resistance.

Since the thermoplastic resin composition concerning the present invention can be easily molded at elevated temperature even if it is not cooled entirely below Tg or crystallization temperature in molding, the productivity of molding can be easily enhanced. In addition, the above-mentioned rate of maintaining a shape is more preferably 80% or more.

In the present invention, the inorganic compound mixed in the above thermosetting resin composition is not particularly limited but it is preferably an inorganic compound having a dispersion particle diameter in the thermosetting resin of 2 $\mu$m or less. Generally, when an inorganic compound is added to a thermoplastic resin, the elastic modulus of a composite material to be obtained or the viscosity at the time of elevated temperature such as the time of thermally melting becomes large. Particularly, when an inorganic compound having a small particle diameter is added, an interface area between the resin and the inorganic compound becomes large and therefore the viscosity of the resin at elevated temperature increases. In the present invention, by mixing an inorganic compound having a dispersion particle diameter of 2 $\mu$m or less, the above-mentioned rate of maintaining a shape of the thermoplastic resin composition is effectively enhanced. Preferably, an inorganic compound having a dispersion particle diameter of 1 $\mu$m or less is used.

Examples of the above inorganic compounds include silica, talc, mica, metal hydroxide, calcium carbonate, silicate and the like. Particularly, as an inorganic compound having a dispersion particle diameter of 2 $\mu$m or less in a resin, fine powder silica containing silicon and oxygen such as fumed silica and AEROSIL is suitably employed because it has a large specific surface area and an area for diffusion into resin becomes large.

In the resin composition concerning the present invention, the inorganic compound having a dispersion particle diameter of 2 $\mu$m or less in a resin is more preferably laminar silicate. The laminar silicate is an inorganic compound in plate form and a large aspect ratio. When the laminar silicate is added, the elastic modulus of a composite material to be obtained or the viscosity at the time of elevated temperature such as the time of thermally melting is enhanced. Particularly, when a crystal of the laminar silicate in flake form is delaminated and highly dispersed in the thermoplastic resin, an interface area between the thermoplastic resin and the laminar silicate becomes very large and therefore the viscosity of the resin at elevated temperature can be enhanced even when a small amount of the laminar silicate is added.

Examples of the above laminar silicates include smectite clay minerals such as montmorillonite, hectorite, saponite, beiderite, stevensite, nontronite and the like, swelling mica, vermiculite, hallosite and the like. Among others, at least one species selected from the group consisting of montmorillonite, hectorite, swelling mica, and vermiculite is suitably used. These laminar silicates may be used alone or in combination of two or more species.

When the laminar silicate is at least one species selected from the group consisting of montmorillonite, hectorite, swellingmica, and vermiculite, the dispersibility of the laminar silicate in resin is enhanced, and an interface area between the resin and the laminar silicate becomes large. Accordingly, the effect of constraining a resin is enhanced, and therefore resin strength and dimensional stability at elevated temperature can be improved.

The configuration of the crystal of the above laminar silicate is not particularly limited, but a preferred lower limit of an average length is 0.01 $\mu$m and a preferred upper limit is 3 $\mu$m, a preferred lower limit of a thickness is 0.001 $\mu$m and a preferred upper limit is 1 $\mu$m and a preferred lower limit of an aspect ratio is 20 and a preferred upper limit is 500, and a more preferred lower limit of an average length is 0.05 $\mu$m and a more preferred upper limit is 2 $\mu$m, a more preferred lower limit of a thickness is 0.01 $\mu$m and a more preferred upper limit is 0.5 $\mu$m and a more preferred lower limit of an aspect ratio is 50 and a more preferred upper limit is 200.

The above laminar silicate preferably has a large effect of shape anisotropy defined by the following equation (1):

$$\text{Effect of shape anisotropy = Area of crystal surface (A)/Area of crystal surface (B)} \quad (1),$$

wherein the crystal surface (A) refers to the surface of a layer and the crystal surface (B) refers to the side of a layer. By employing the laminar silicate having a large effect of shape anisotropy, a resin obtained from the resin composition of the present invention has excellent mechanical properties.

An exchangeable metal cation existing between layers of the above laminar silicate refers to an ion of metal such as sodium or calcium, which exists at the surface of the crystal of the laminar silicate in flake form. Since these metal ions have a property of exchanging cations with a cationic material, it is possible to intercalate various materials having a cationic property between crystal layers of the above laminar silicate.

A cation-exchange capacity of the above laminar silicate is not particularly limited, but a preferred lower limit of the cation-exchange capacity is 50 meq/100 g and a preferred upper limit is 200 meq/100 g. When the cation-exchange capacity is less than 50 meq/100 g, an amount of a cationic material intercalated between crystal layers of the laminar silicate by the cation-exchange becomes less and therefore a portion between crystal layers may not be adequately non-polarized (converted to a hydrophobic substance). When the cation-exchange capacity is more than 200 meq/100 g, the crystal in flake form may be hardly delaminated because the binding force between crystal layers of the laminar silicate becomes too strong.

The above laminar silicate is preferably a substance which is chemically treated to have improved dispersibility in resin. Hereinafter, the laminar silicate thus treated is also referred to as an organized laminar silicate. The above-mentioned chemical treatment can be performed by, for example, methods of from chemical modification (1) to chemical modification (6) described later. These methods of chemical modification may be used alone or in combination of two or more species of them.

The above method of chemical modification (1) is also referred to as a cation-exchange method by a cationic surfactant and specifically a method in which an interlaminar portion of laminar silicate is cation-exchanged with a cationic surfactant and converted to a hydrophobic substance in advance when obtaining the resin composition of the present invention using a resin of the low polarity. By converting the interlaminar portion of laminar silicate to a hydrophobic substance in advance, an affinity of the laminar silicate for a resin of the low polarity is enhanced and thereby the laminar silicate can be more uniformly dispersed finely in the resin of the low polarity.

The above-mentioned cationic surfactant is not particularly limited and examples of the cationic surfactants include quaternary ammonium salt, quaternary phosphonium salt and the like. Among others, alkyl ammonium ion having six or more carbon atoms, aromatic quaternary ammonium ion or heterocyclic quaternary ammonium ion is suitably used because a portion between crystal layers of the laminar silicate can be adequately converted to a hydrophobic substance.

The above quaternary ammonium salt is not particularly limited and examples of them include trimethyl alkyl ammonium salt, triethylalkylammonium salt, tributylalkylammonium salt, dimethyldialkylammonium salt, dibutyldialkylammonium salt, methylbenzylalkylammonium salt, dibenzyldialkylammoniumsalt, trialkylmethylammonium salt, trialkylethylammonium salt, trialkylbutylammonium salt; quaternary ammonium salts having an aromatic ring such as benzylmethyl{2-[2-(p-1,1,3,3-tetramethylbutylphenoxy)ethoxy]ethyl}ammonium chloride; quaternary ammonium salts derived from aromatic amine such as trimethylphenylammonium; quaternary ammonium salts having a heterocycle such as alkylpyridinium salt and imidazolium salt; dialkyl quaternary ammonium salts having two polyethylene glycol chains, dialkyl quaternary ammonium salts having two polypropylene glycol chains, trialkyl quaternary ammonium salts having a polyethylene glycol chain, and trialkyl quaternary ammonium salts having a polypropylene glycol chain. Among others, lauryl trimethyl ammonium salt, stearyl trimethyl ammonium salt, trioctylmethylammonium salt, distearyl dimethyl ammonium salt, dehydrogenated tallow dimethyl ammonium salt, distearyl dibenzyl ammonium salt, and N-polyoxyethylene-N-lauryl-N,N-dimethyl ammonium salt are suitable. These quaternary ammonium salts may be used alone or in combination of two or more species.

The above-mentioned quaternary phosphonium salt is not particularly limited and examples of them include dodecyltriphenylphosphonium salt, methyltriphenylphosphonium salt, lauryl trimethyl phosphonium salt, stearyl trimethyl phosphonium salt, trioctylmethylphosphonium salt, distearyl dimethyl phosphonium salt, and distearyl dibenzyl phosphonium salt. These quaternary phosphonium salts may be used alone or in combination of two or more species.

The above method of chemical modification (2) is a method of chemically treating a hydroxyl group, which exists at the surface of a crystal of an organized laminar silicate prepared by chemically treating the laminar silicate by the method of chemical modification (1), with a compound having one or more functional groups capable of chemically bonding to a hydroxyl group or one or more functional groups having a large chemical affinity for a hydroxyl group on a terminal of a molecule.

The above-mentioned functional group capable of chemically bonding to a hydroxyl group or functional group having a large chemical affinity for a hydroxyl group is not particularly limited and examples of these functional groups include an alkoxy group, a glycidyl group, a carboxyl group (including dibasic acid anhydride), a hydroxyl group, an isocyanate group and an aldehyde group.

The above-mentioned compound having the functional group capable of chemically bonding to a hydroxyl group or the above-mentioned compound having the functional group having a large chemical affinity for a hydroxyl group is not particularly limited and examples of these compounds include a silane compound, a titanate compound, a glycidyl compound, carboxylic acids, sulfonic acids and alcohols, which have the above functional group. These compounds may be used alone or in combination of two or more species.

The above-mentioned silane compound is not particularly limited and examples of the silane compounds include vinyltrimethoxysilane, vinyltriethoxysilane, vinyltris(β-methoxyethoxy)silane, γ-aminopropyltrimethoxysilane, γ-aminopropylmethyldimethoxysilane, γ-aminopropyldimethylmethoxysilane, γ-aminopropyltriethoxysilane, γ-aminopropylmethyldiethoxysilane, γ-aminopropyldimethylethoxysilane, methyltriethoxysilane, dimethyldimethoxysilane, trimethylmethoxysilane, hexyltrimethoxysilane, hexyltriethoxysilane, N-β-(aminoethyl)γ-aminopropyltrimethoxysilane, N-β-(aminoethyl)γ-aminopropyltriethoxysilane, N-β-(aminoethyl)γ-aminopropylmethyldimethoxysilane, octadecyltrimethoxysilane, octadecyltriethoxysilane, γ-methacryloxypropylmethyldimethoxysilane, γ-methacryloxypropylmethyldiethoxysilane, γ-methacryloxypropyltrimethoxysilane, and γ-methacryloxypropyltriethoxysilane. These silane compounds may be used alone or in combination of two or more species.

The above method of chemical modification (3) is a method of chemically treating a hydroxyl group, which exists at the surface of a crystal of an organized laminar silicate prepared by chemically treating the laminar silicate by the method of chemical modification (1), with a functional group capable of chemically bonding to a hydroxyl group or a functional group having a large chemical affinity for a hydroxyl group, and a compound having one or more reactive functional group on a terminal of a molecule.

The above method of chemical modification (4) is a method of chemically treating the surface of a crystal of an organized laminar silicate prepared by chemically treating the laminar silicate by the method of chemical modification (1) with a compound having an anionic surface activity.

A compound having the above anionic surface activity is not particularly limited as long as it can chemically treat the laminar silicate by ionic interaction. Examples of the above compounds having the anionic surface activity include sodium laurate, sodiumstearate, sodium oleate, higher alcohol sulfuric acid salt, secondary higher alcohol sulfuric acid salt, and unsaturated alcohol sulfuric acid salt. These compounds may be used alone or in combination of two or more species of them.

The above method of chemical modification (5) is a method of chemically treating with a compound having one or more reactive functional groups at a site other than an anion site in a molecular chain among the above compound having the anionic surface activity.

The above method of chemical modification (6) is a method of using further a resin having a functional group capable of reacting with laminar silicate such as maleic anhydride modified polyphenylene ether resin for an organized laminar silicate prepared by chemically treating the laminar silicate by any one of the methods of from chemical modification (1) to chemical modification (5).

The above laminar silicate is preferably dispersed in the resin composition of the present invention in such a way that an average interlayer distance of a (001) plane, measured by a wide-angle X-ray diffraction measuring method, is 3 nm or larger and a part of or all of laminates become a laminate of five layers or less. By dispersing the laminar silicate in such a way that the above-mentioned average interlayer distance is 3 nm or larger and a part of or all of laminates become a laminate of five layers or less, an interface area between resin and laminar silicate becomes adequately large. Further, a distance between crystals of the laminar silicate in flake form becomes proper and effects of improvement in properties at elevated temperature, mechanical properties, heat resistance and dimensional stability by virtue of dispersion can be adequately attained.

A preferred upper limit of the above average interlayer distance is 5 nm. When the above average interlayer distance is larger than 5 nm, the crystal in flake form of the laminar silicate is separated in every layer and an interaction becomes weak nonsignificantly, and therefore constraining strength at elevated temperature may be reduced and adequate dimensional stability may not be attained.

In addition, in the present specification, the average interlayer distance of the laminar silicate refers to an average of an interlayer distance in the case where a crystal of the laminar silicate in flake form is considered as a layer. The average interlayer distance can be determined by peaks of X-ray diffraction and a transmission electron microphotograph, namely, a wide-angle X-ray diffraction measuring method.

That the laminar silicate is dispersed in such a way that a part of or all of laminates become a laminate of five layers or less, as described above, means specifically that an interaction between the crystals in flake form of the laminar silicate is reduced and a part of or all of a laminate of the crystals in flake is dispersed. Not less than 10% of the laminate of the laminar silicate is preferably dispersed in a state of five layers or less and not less than 20% of the laminate of the laminar silicate is more preferably dispersed in a state of five layers or less.

In addition, a rate of laminar silicate dispersed in the form of a laminate of five layers or less in a resin composition can be derived from the following equation (2), using the number X of layers in total laminates and the number Y of layers in laminates dispersed in the form of a laminate of five layers or less among the total laminates, which have been determined by observing the resin composition under a magnification of 50000 times to 100000 times with a transmission electron microscope and counting the number of laminates of laminar silicate which can be observed in a certain area and the number of layers in these laminates.

$$\text{Rate of laminar silicate dispersed in the form of a laminate of five layers or less (\%)} = (Y/X) \times 100 \quad (2)$$

And, number of layers laminated in a laminate of laminar silicate is preferably 5 or less to attain an effect of the dispersion of laminar silicate, more preferably 3 or less, and furthermore preferably 1.

In the resin composition of the present invention, when laminar silicate, in which an average interlayer distance of a (001) plane, measured by a wide-angle X-ray diffraction measuring method, is 3 nm or larger and a part of or all of laminates are a laminate of five layers or less, is dispersed, an interface area between the resin and the laminar silicate becomes adequately large and an interaction between the resin and the surface of the laminar silicate becomes large. Therefore, melt viscosity is enhanced, a property of thermoforming such as hot pressing is improved, and in addition to this a shape of an article molded by texturing or embossing is easy to maintain, and mechanical properties such as elastic modulus is improved in a wide temperature range of from room temperature to elevated temperature. Further, mechanical properties can be maintained even at a high temperature of a glass transition point Tg or a melting point of resin minus 20°C or higher and a linear expansion coefficient at elevated temperature can also be suppressed. The reason for this is not clear, but it is considered that these properties are exerted because the laminar silicate in a state of dispersing finely acts as a kind of quasi-crosslinking point even in a temperature range of a glass transition point Tg or a melting point minus 20°C or higher. And, it is considered that since this quasi-crosslinking point does not contain a covalent bond, this quasi-crosslinking point is not maintained at a given shear rate and therefore sufficient fluidity is retained in thermoforming. On the other hand, since a distance between crystals of the laminar silicate in flake form also becomes proper, a sintered body, in which the crystal of the laminar silicate in flake moves to form a flame retardant film in firing, becomes apt to be formed. Since this sintered body is formed at the early stage in firing, this sintered body can cut off not only an external supply of oxygen but also a flammable gas produced by combustion, and therefore the resin composition of the present invention exerts excellent flame retardancy.

Further, since in the above resin composition, the laminar silicate is finely dispersed in a size of nanometer, the resin composition is excellent in transparency. And, processing by drill hole boring or laser hole boring is easy since there are not localized inorganic compound pieces of the large size.

A method of dispersing laminar silicate in a thermoplastic resin is not particularly limited and includes, for example, a method of using organized laminar silicate, a method of mixing resin and laminar silicate by normal technique, a method of using a dispersant and a method of mixing laminar silicate into resin in a state of being dispersed in a solvent.

As for an amount of the above inorganic compound to be mixed with respect to 100 parts by weight of the above thermoplastic resin, a lower limit of the amount to be mixed is 0.1 parts by weight and an upper limit is 100 parts by weight. When the amount of the above inorganic compound to be mixed is less than 0.1 parts by weight, effects of improvements in properties at elevated temperature and water absorption become small and the ability to maintain a shape after temperature raising is deteriorated. When the amount of the above inorganic compound to be mixed is more than 100 parts by weight, the resin composition becomes poor in practicality because the density (specific gravity) of the resin composition of the present invention increases and the mechanical strength of the resin composition is deteriorated. A more preferred lower limit of the amount of the above inorganic compound to be mixed is 1 part by weight and a more preferred upper limit is 80 parts by weight. When the amount of the above inorganic compound to be mixed is less than 1 part by weight, an adequate effect of improvement in properties at elevated temperature may not be attained in molding the resin composition of the present invention into a low-profile article. When the amount of the above inorganic compound to be mixed is more than 80 parts by weight, moldability maybe deteriorated. And, when the amount of the above inorganic compound to be mixed is 5 to 40 parts by weight, there is not a problematic region in mechanical properties and suitability for a process, and the ability to maintain a shape and sufficient properties at elevated temperature after molding, and low water absorption are attained.

When molding the resin composition into a desired shape, the resin composition preferably contains the laminar silicate in an amount 0.2 to 40 parts by weight with respect to 100 parts by weight of the above thermoplastic resin composition. The resin composition more preferably contains the laminar silicate in an amount 0.5 to 20 parts by weight, and furthermore preferably contains the laminar silicate in an amount 1.0 to 10 parts by weight with respect to 100 parts by weight of the above thermoplastic resin composition. When the amount of the laminar silicate contained is less than 0.2 parts by weight, mechanical properties after molding may be deteriorated, and when the amount of the laminar silicate contained is more than 40 parts by weight, the viscosity of resin increases and it becomes difficult to mold the resin composition into a desired shape.

And, when the thermoplastic resin composition contains an inorganic compound other than laminar silicate, the thermoplastic resin composition preferably contains the laminar silicate and the inorganic compound in the proportions in a range of 1:1 to 1:20. When the proportions fall within a range of 1:1 to 1:20, the viscosity of resin does not significantly increase and further mechanical properties can be improved. Therefore, when the proportions fall within a range of 1:1 to 1: 20, the resin composition is excellent in the ability to follow and the flatness since a flow property becomes good, and it is further excellent in the mechanical properties.

The thermoplastic resin composition concerning the present invention has excellent properties at elevated temperature and, as described above, is characterized in that the inorganic compound is mixed in an amount 0.1 to 100 parts by weight with respect to 100 parts by weight of the thermoplastic resin. Here, the thermoplastic resin to be usedmay be semisolid or may be solid at room temperature and includes resins to be plasticized by heating widely.

Examples of the above thermoplastic resins include polyolefin resins, a polystyrene resin, a polyamide resin, a polyester resin, a poly(meth)acrylate resin, a polyphenylene ether resin, a functional group modified polyphenylene ether resin, a mixture of a polyphenylene ether resin or a functional group modified polyphenylene ether resin and a thermoplastic resin, such as a polystyrene resin, capable of being compatible with a polyphenylene ether resin or a functional group modified polyphenylene ether resin, an alicyclic hydrocarbon resin, a thermoplastic polyimide resin; a polyether ether ketone resin, a poly ether sulfone resin; a polyamideimide resin, a polyester imide resin, a polyester resin, a polyvinyl acetal resin, a polyvinyl alcohol resin, a polyvinyl acetate resin, a polyoxymethylene resin, a polyetherimide resin, and a thermoplastic polybenzimidazole resin. Among others, polyolefin resins, a poly(meth)acrylate resin, a polyphenylene ether resin, a functional group modified polyphenylene ether resin, a mixture of a polyphenylene ether resin or a functional group modified polyphenylene ether resin and a polystyrene resin, an alicyclic hydrocarbon resin, a thermoplastic polyimide resin, a polyether ether ketone resin, a polyester imide resin, a polyetherimide resin, and a thermoplastic polybenzimidazole resin are suitably used. These thermoplastic resins may be used alone or in combination of two or more species. In addition, herein, the term (meth) acrylate means acrylate or methacrylate.

The above-mentioned polyphenylene ether resin is a polyphenylene ether homopolymer consisting of repeat units expressed by the following formula (1A):

[Formula 1]

(1A),
or a copolymer of polyphenylene ether.

In the above formula (1A), $R^1$, $R^2$, $R^3$ and $R^4$ represent a hydrogen atom, an alkyl group, an aralkyl group, an aryl group or an alkoxy group. These alkyl group, aralkyl group, aryl group and alkoxy group each may be replaced with a functional group.

The above-mentioned polyphenylene ether homopolymer includes, for example, poly(2,6-dimethyl-1,4-phenylene)ether, poly(2-methyl-6-ethyl-1,4-phenylene)ether, poly(2,6-diethyl-1,4-phenylene)ether, poly(2-ethyl-6-n-propyl-1,4-phenylene)ether, poly(2,6-di-n-propyl-1,4-phenylene)ether, poly(2-ethyl-6-n-butyl-1,4-phenylene)ether, poly(2-ethyl-6-isopropyl-1,4-phenylene)ether, and poly(2-methyl-6-hydroxyethyl-1,4-phenylene)ether.

The above-mentioned copolymer of polyphenylene ether includes, for example, a copolymer formed by including a phenol derivative, such as 2,3,6-trimethylphenol, having three alkyl substituents partially in repeat units of the above polyphenylene ether homopolymer, and a copolymer formed by further graft copolymerizing one or more species of styrenic monomers such as styrene, α-methyl styrene, vinyl toluene and the like onto these polyphenylene ether copolymers. These polyphenylene ethers may be used alone or in combination of two or more species of polyphenylene ether resins having different composition, components and molecular weights.

Examples of the above functional group modified polyphenylene ether resins include resins obtained by modifying the above polyphenylene ether resin with one or more species of functional groups such as a maleic anhydride group, a glycidyl group, an amino group, an allyl group and the like. These functional group modif ied polyphenylene ether resins may be used alone or in combination of two or more species. When the above functional group modified polyphenylene ether resin is used as a thermoplastic resin, the mechanical properties, the heat resistance and the dimensional stabilityof the resin composition of the present invention can be more improved by crosslinking reaction.

The above-mentioned mixture of a polyphenylene ether resin or a functional group modified polyphenylene ether resin and a polystyrene resin includes, for example, mixtures formed by mixing the above polyphenylene ether resin or the above functional group modified polyphenylene ether resin with a styrene homopolymer; or a copolymer of styrene and one or more species of styrenic monomers such as α-methylstyrene, ethylstyrene, t-butylstyrene and vinyl toluene; or a polystyrene resin such as styrenic elastomer.

The above-mentioned polystyrene resins may be used alone or in combination of two or more species. These mixtures of a polyphenylene ether resin or a functional group modified polyphenylene ether resin and a polystyrene resin may be used alone or in combination of two or more species.

The above-mentioned alicyclic hydrocarbon resin is a hydrocarbon resin having a cyclic hydrocarbon group in a high polymer chain and includes, for example, a cyclic olefin, or homopolymer or copolymer of norbornene monomer. These alicyclic hydrocarbon resins may be used alone or in combination of two or more species.

Examples of the above-mentioned cyclic olefins include norbornene, methanooctahydronaphthalene, dimethanooctahydronaphthalene, dimethanododecahydroanthracene, dimethanodecahydroanthracene, trimethanododecahydroanthracene, dicyclopentadiene, 2,3-dihydrocyclopentadiene, methanooctahydrobenzoindene, dimethanooctahydrobenzoindene, methanodecahydrobenzoindene, dimethanodecahydrobenzoindene, methanooctahydrofluorene, dimethanooctahydrofluorene and substitution products thereof. These cyclic olefins may be used alone or in combination of two or more species.

Examples of substituents in the above-mentioned substitution products of norbornene and the like include publicly known hydrocarbon groups and polar groups such as an alkyl group, an alkylidene, an aryl group, a cyano group, an alkoxycarbonyl group, a glycidyl group, a pyridyl group, and a halogen atom. These substituents may be used alone or in combination of two or more species.

Examples of the above-mentioned substitution products of norbornene and the like include 5-methyl-2-norbornene, 5,5-dimethyl-2-norbornene, 5-ethyl-2-norbornene, 5-butyl-2-norbornene, 5-ethylidene-2-norbornene, 5-methoxycarbonyl-2-norbornene, 5-cyano-2-norbornene, 5-methyl-5-methoxycarbonyl-2-norbornene, 5-phenyl-2-norbornene, and 5-phenyl-5-methyl-2-norbornene.

These substitution products of norbornene and the like may be used alone or in combination of two or more species.

A commercially available resin among the above alicyclic hydrocarbon resins includes, for example, a trade name "ARTON" series produced by JSR CORPORATION and a trade name "ZEONOR" series produced by ZEON CORPORATION.

Examples of the above-mentioned thermoplastic polyimide resins include a polyetherimide resin having an imide bond and an ether bond in a main chain of a molecule, a polyamide-imide resin having an imide bond and an amide bond in a main chain of a molecule, and a polyesterimide resin having an imide bond and an ester bond in a main chain of a molecule. And, a raw material to be used is not particularly limited and examples of the materials include tetracarboxylic anhydrides consisting of pyromelletic anhydride, 3,3',4,4'-benzophenonetetracarboxylic dianhydride, 3,3',4,4'-biphenyltetracarboxylic dianhydride, 3,3',4,4'-diphenylsulfonetetracarboxylic dianhydride, 3,3',4,4'-diphenylethertetracarboxylic dianhydride, ethylene glycol bis(anhydrotrimethate), (5-dioxotetrahydro-3-furanyl)-3-methyl-3-cyclohexene-1,2-di carboxylic anhydride and 1,3,3a,4,5,9b-hexahydro-5-(tetrahydro-2,5-dioxo-3-furanyl)n aphtha[1,2-c]furan-1,3-dion, and diamines such as 4,4'-bis(3-aminophenoxy)biphenyl, bis[4-(3-aminophenoxy)phenyl]sulfone, 1,3-bis(4-aminophenoxy)benzene and 4,4'-diaminodiphenyl ether.

The above thermoplastic polyimide resins may be used alone or in combination of two or more species. A commercially available resin among the above thermoplastic polyimide resins includes, for example, a trade name "AURUM" produced by Mitsui Chemicals, Inc.

The above-mentioned polyether ether ketone resin includes, for example, a resin obtained by polycondensating dihalogeno benzophenone and hydroquinone and the like. A commercially available resin among the above polyether ether ketone resins includes, for example, a trade name "Victrex PEEK" produced by Imperial Chemical Industries PLC.

The above-mentioned thermoplastic polybenzimidazole resin includes, for example, a resin obtained by polycondensating dioctadecylterephthalaldimine and 3,3'-diaminobenzidine and the like. Commercially available resin includes, for example, a trade name "CERASOL" series produced by Clariant Ltd.

The above-mentioned polyolefin resin includes, for example, copolymers of low density polyethylene, linear low density polyethylene, high density polyethylene, or ethylene and α-olefins such as propylene, butane, pentene, hexene and the like; and copolymers of propylene, or ethylene and acrylate, methacrylate, or acrylic acid.

The above-mentioned (meth)acrylate resin is a (meth)acrylate homopolymer or a copolymer of (meth)acrylate.

As the above (meth)acrylate, there are suitably used (meth) acrylates expressed by a general formula $CH_2=C(R^1)COO-R^2$, wherein $R^1$ represents a hydrogen atom or a methyl group (representing a hydrogen atom in the case of acrylate and a methyl group in the case of methacrylate) and $R^2$ represents a monovalent group selected from an aliphatic hydrocarbon group, an aromatic hydrocarbon group, and a hydrocarbon group containing a functional group such as halogen, amine, ether and the like.

The specific example of the above (meth)acrylate resin is not particularly limited and examples of (meth) acrylates resin include, for example, methyl (meth)acrylate, ethyl (meth)acrylate, n-propyl (meth)acrylate, isopropyl (meth)acrylate, n-butyl (meth)acrylate, isobutyl (meth)acrylate, sec-butyl (meth)acrylate, t-butyl (meth) acrylate, isoamyl (meth) acrylate, n-hexyl (meth) acrylate, cyclohexyl (meth)acrylate, 2-ethylhexyl (meth)acrylate, n-octyl (meth)acrylate, lauryl (meth)acrylate, n-tridecyl (meth) acrylate, myristyl (meth) acrylate, cetyl(meth)acrylate, stearyl (meth)acrylate, allyl (meth)acrylate, vinyl (meth) acrylate, benzyl (meth) acrylate, phenyl (meth) acrylate 2-naphtyl (meth)acrylate, 2,4,6-trichlorophenyl (meth)acrylate, 2,4,6-tribromophenyl (meth)acrylate, isobornyl (meth)acrylate, 2-methoxyethyl (meth)acrylate, 2-ethoxyethyl (meth)acrylate, diethylene glycol monomethyl ether (meth)acrylate, polyethylene glycol monomethyl ether (meth)acrylate, polypropylene glycol monomethyl ether (meth)acrylate, tetrahydrofluoryl (meth)acrylate, 2,3-dibromopropyl (meth)acrylate, 2-chloroethyl (meth)acrylate, 2,2,2-trifluoroethyl (meth)acrylate, hexafluoroisopropyl (meth)acrylate, glycidyl (meth)acrylate, 3-trimethoxysilylpropyl (meth)acrylate, 2-diethylaminoethyl (meth)acrylate, 2-dimethylaminoethyl (meth)acrylate, and t-butylaminoethyl (meth)acrylate. These (meth)acrylate resins may be used alone or in combination of two or more species.

The above thermoplastic resin preferably has a glass transition point of 80°C or higher and a dielectric constant of 4.5 or less at 1 MHz. By having a glass transition point of 80°C or higher and a dielectric constant of 4.5 or less at 1 MHz, a resin material consisting of the a resin composition of the present invention results in improved properties at elevated temperature, particularly improved lead-free solder heat resistance and improved dimensional stability. Therefore, it can attain high reliability required of electronic materials and a transmission speed required of electronic materials in a signal transmission speed in a high-frequency range. The glass transition point is more preferably 100°C or higher, and furthermore preferably 120°C or higher. The dielectric constant at 1 MHz is more preferably 4.0 or less, and furthermore preferably 3.6 or less.

Thermoplastic elastomers may be mixed in the resin composition of the present invention to the extent of not impairing the attainment of issues of the present invention. These thermoplastic elastomers are not particularly limited and examples of them include styrenic elastomers, olefin elastomers, urethane elastomers, polyester elastomers and the like. These thermoplastic elastomers may be functional group modified in order to enhance compatibility with resin. These thermoplastic elastomers may be used alone or in combination of two or more species.

Crosslinked rubbers may be mixed in the resin composition of the present invention to the extent of not impairing the attainment of issues of the present invention. These crosslinked rubbers are not particularly limited and examples of them include isoprene rubber, butadiene rubber, 1,2-polybutadiene, styrene-butadiene rubber, nitrile rubber, butyl rubber, ethylene-propylene rubber, silicone rubber, urethane rubber and the like. These crosslinked rubbers are preferably functional group modified in order to enhance compatibility with resin. The above functional group modified crosslinked rubbers are not particularly limited and examples of them include epoxy modified butadiene rubber, epoxy modified nitrile rubber and the like. These crosslinked rubbers may be used alone or in combination of two or more species.

The material for substrates and the film for substrates concerning the present invention are characterized by being composed by using the thermoplastic resin composition concerning the present invention. In this case, molded shapes of the material for substrates and the film for substrates are not particularly limited but the heat resistance of the material for substrates and the film for substrates is enhanced by using the thermoplastic resin composition concerning the present invention. Accordingly, the material for substrates, having various shapes, can be formed according to the present invention. And, the material for substrates and the film for substrates concerning the present invention are excellent in mechanical properties and dimensional stability since the inorganic compound is mixed in the thermoplastic resin in the above-mentioned specific amount.

And, in the thermoplastic resin composition of the present invention, the inorganic compound is dispersed finely, particularly preferably in a size of nanometer in the thermoplastic resin, it is possible to realize high transparency in addition to a low linear expansion coefficient, heat resistance and low water absorption. Therefore, the thermoplastic resin composition of the present invention can be suitably used also as materials for forming an optical package, materials for forming an optical circuit such as a material for optical waveguides, a material for polymer optical fiber, a connecting material and a sealing material, and materials for optical communications.

When the thermoplastic resin composition is used as the above material for optical communications, as a light source used for the optical communications, an arbitrary light source, which produces an arbitrary wavelength such as visible light, infrared rays and ultraviolet rays, can be used and examples of these light sources include laser, a light-emitting diode, a xenon lamp, an arc lamp, an light bulb and a fluorescent lamp.

The thermoplastic resin composition of the present invention can be employed as a core layer and/or a clad layer of an optical waveguide. The optical waveguide is composed of a core layer through which light is passed and a clad layer which is in contact with the core layer. If a refractive index of the core layer is denoted by Nk and a refractive index of the clad layer is denoted by Ng, the core layer having a small attenuation factor of light and the clad layer in contact with the core layer, which has a different refractive index, are constructed so as to satisfy the relationship of Nk > Ng with respect to light used for a light source.

Examples of the materials, which can be used as the above-mentioned core layer or clad layer other than the thermoplastic resin composition of the present invention, include glass, quartz, an epoxy resin, a nonthermoplastic fluororesin, a silicon resin, a polysilane resin, an acrylic resin, and a fluorinated polyimide resin.

And, the thermoplastic resin composition of the present invention can be used for a material for sensors in which a planar optical waveguide consisting of a core layer in flat plate form and a clad layer in thin flat plate form is formed, and a medium is provided for the thin clad layer on the side opposite to the core layer and light (evanescent wave) exuding to the medium side is used.

When the thermoplastic resin composition of the present invention is used as the above-mentioned material for forming an optical circuit, a method of forming an optical circuit is, for example, as follows. A thermosetting acrylic resin composition is dissolved in a solvent, and the resulting solution is applied onto a glass epoxy substrate by spin coating as a lower clad layer and heated to form a lower clad, and thereon, a core layer, which uses the resin composition of the present invention having a higher refractive index than the lower clad layer and consisting of an acrylic resin of a thermoplastic resin, is formed by thermoforming. After this, the core layer is patterned by dry etching, and further an upper clad layer, which uses the resin composition of the present invention having a lower refractive index than the core layer and consisting of an acrylic resin of a thermoplastic resin, is formed by thermoforming to form an optical circuit.

A method of molding the resin composition of the present invention is not particularly limited and examples of these methods include an extrusion process in which the resin composition is melted and kneaded and then extruded with an extruder, and the extruded resin is molded into film form with a T die or a circular die; a casting process in which the resin composition is dissolved or dispersed in a solvent such as an organic solvent and the like, and then molded into film form by casting; and a dip molding process in which a base material, consisting of an inorganic material such as glass or an organic polymer, in cloth form or nonwoven fabric form is molded into film form by dipping this base material in varnish prepared by dissolving or dispersing the resin composition in a solvent such as an organic solvent and the like. In addition, the base material used in the above-mentioned dip molding process is not particularly limited and include, for example, glass cloth, aramid fiber and poly(p-phenylene benzoxazole) fiber.

The resin composition of the present invention obtained by the above-mentioned method is very suitable for usual molding of a plastic resin such as injection molding, compression molding, hot-melt extrusion, heat laminating, and SCM molding and also suitable for molding of transferring a desired core pattern using a die (stamper).

As described above, the thermoplastic resin composition concerning the present invention and a resin sheet composed by using such a thermoplastic resin composition are excellent in transparency. Accordingly, alignment becomes easy in the case where the resin composition and resin sheet are used as a material of a clad layer in a core layer of a waveguide or as a base in applications such as a digital versatile disc (DVD) and a compact disc (CD) and a shape of a die is transferred to or formed on the resin composition concerning the present invention or in the case of laminating the resin composition concerning the present invention as a electrical and electric material, particularly an insulating film or an adhesive film on a base material. Further, it also becomes easy to identify the presence of void due to involved air.

(Examples)

Hereinafter, the present invention will be described in detail by having specific examples of the present invention. However, the present invention is not limited to the following examples.

(Example 1)

52 parts by weight of methyl methacrylate as a thermoplastic resin, 50 parts by weight of isobornyl acrylate as a thermoplastic resin, 56.3 parts by weight of ion-exchange water, 33.8 parts by weight of sodium dodecylbenzene sulphonate as a dispersant, and 0.058 parts by weight of mercaptoethanol as a chain transfer agent were mixed and stirred to prepare an emulsified monomer solution.

On the other hand, in a 1 liter glass reactor, 225 parts by weight of residual ion-exchange water and 20.4 parts by weight of synthetic hectorite (SAN produced by CO-OP CHEMICAL CO. , LTD.) were put, and the resulting mixture was stirred. After oxygen in a vessel was removed by reducing a pressure of the polymerization vessel, the vessel pressure was increased to atmospheric pressure by nitrogen addition to bring the interior of the vessel into an atmosphere of nitrogen. After this, a temperature of the polymerization vessel was raised to 70°C. 0.51 parts by weight of ammonium persulfate was added to the content of the polymerization vessel, and then the above emulsified monomer solution was added dropwise to the polymerization vessel to initiate polymerization. This dropwise addition of the monomer was performed over 60 minutes, and after this, aging was performed for 1 hour and then the polymerization vessel was cooled to room temperature to obtain slurry having a solid content of about 25% by weight, which contains a composite of laminar silicate having an average particle diameter of about 15 $\mu$m and resin.

After leaving this slurry at rest to dry at room temperature, molded bodies in plate form having a thickness of 1 mm and 100 $\mu$m were prepared by hot pressing at 160°C.

On the molded bodies in plate form thus prepared, a glass transition point was measure, and consequently the glass transition point was 111°C.

And, (1) Measurement of thermal expansion coefficient, (2) Total light transmittance, (3) Measurement of average interlayer distance of laminar silicate, (4) Rate of laminar silicate dispersed in the form of a laminate of five layers or less, (5) Dispersion particle diameter of laminar silicate in resin, and (6) Rate of maintaining shape were evaluated according to the methods of evaluation described later. The results of evaluations are shown in Table 1.

(Example 2)

When the proportions of the laminar silicate to be mixed is 80 to 100 parts by weight with respect to 100 parts by weight of the thermoplastic resin, it become difficult to disperse the laminar silicate by a polymerization method, and therefore a resin composition was prepared using an extruder.

In a small extruder "TEX 30" (manufactured by Japan Steel Works, LTD.), a low density polyethylene resin ("LE520" produced by Japan Polychem Corporation) as a thermoplastic resin, maleic anhydride modified polyethylene oligomer ("UMEX" produced by Sanyo Chemical Industries, Ltd. : functional group content 0.23 mmol/g) as a thermoplastic resin, and synthetic hectorite organized with dimethyloctadecyl quaternary ammonium salt (LUCENTITE SAN manufactured by CO-OP CHEMICAL CO., LTD.) were fed in the proportions of 93 parts by weight : 7 parts by weight : 80 parts by weight, and the resulting mixture was melted and kneaded at a set temperature of 180°C, and extruded strand was palletized with a pelletizer.

Bodies in plate form having a thickness of 100 $\mu$m and 1 mm were molded from the obtained pellet by hot pressing where temperature is controlled at 160°C to obtain samples for evaluations.

A melting point of the molded body was measured at a temperature raising rate of 10 °C/minute with a differential scanning calorimeter (DSC) (EXSTAR 6200 manufactured by Seiko Instrument Inc.). A peak of the low density polyethylene resin and a weak peak of the maleic anhydride modified polyethylene oligomer were recognized, but a temperature (105°C) of the peak of the low density polyethylene resin which makes up most of the peaks in the resin composition is considered to be a melting point.

(Example 3)

Molded bodies in plate form were prepared by following the same procedure as in Example 1 except for using 4 parts by weight of synthetic hectorite (LUCENTITE SAN produced by CO-OP CHEMICAL CO., LTD.) with respect to 100 parts by weight of the thermoplastic resin. A glass transition point of the molded body was measure, and consequently the glass transition point Tg was 109°C.

(Comparative Example 1)

A thermoplastic resin composition and molded bodies were prepared and evaluated by following the same procedure as in Example 1 except for not mixing synthetic hectorite (LUCENTITE SAN produced by CO-OP CHEMICAL CO., LTD.). Consequently, the glass transition point Tg of the molded body was 94°C.

(Comparative Example 2)

Molded bodies in plate form were prepared by following the same procedure as in Example 2 except for feeding synthetic hectorite (LUCENTITE SAN produced by CO-OP CHEMICAL CO., LTD.) so as to be in the proportions of 120 parts by weight with respect to 100 parts by weight of the thermoplastic resin. As for a melting point of the molded body, 105°C was considered to be a melting point as with Example 2.

(1) Measurement of thermal expansion coefficient

With respect to a test piece prepared by cutting each molded body in plate form having a thickness of 100 $\mu$m into a size of 3 mm $\times$ 25 mm, using a TMA (thermomechanical analysis) apparatus (TMA/SS120C manufactured by Seiko Instrument Inc.), its temperature was increased at a temperature raising rate of 5°C/minute and its average linear expansion coefficient was measured to determine the following items.

- An average linear expansion coefficient ($\alpha$1) at a temperature lower than the glass transition point of a resin composition by from 50°C to 10°C [°C$^{-1}$].
- An average linear expansion coefficient ($\alpha$2) at a temperature higher than the glass transition point of a resin composition by from 10°C to 50°C [°C$^{-1}$].

(2) Measurement of total light transmittance

A minimum value of light transmittance in a wavelength range of light required in accordance with uses is treated as total light transmittance, and in Example and Comparative Examples, the total light transmittance is determined in a wavelength range of 190 to 3200 nm. The transmittance can be measured with UV-VIS Spectrophotometers (UV-3150 manufactured by SHIMADZU CORPORATION).

(3) Average interlayer distance of laminar silicate

2$\theta$ of a diffraction peak obtained from the diffraction of a laminating face of the laminar silicate in the molded body in plate form having a thickness of 100 $\mu$m was measured using a X-ray diffractometer (RINT 1100 manufactured by Rigaku Corporation.). Spacingdof a (001) plane of the laminar silicate was derived from the Bragg condition of the following equation (3) :

$$\lambda\ =\ 2\mathrm{dsin}\theta\quad(3),$$

and the obtained d is taken as an average interlayer distance (mm). In the above equation (3), $\lambda$ is 0.154 angstrom and $\theta$ represents a diffraction angle.

(4) Rate of laminar silicate dispersed in the form of a laminate of five layers or less

A molded body in plate form having a thickness of 100 $\mu$m was observed under a magnification of 100000 times with a transmission electron microscope, and by counting the number of laminates of laminar silicate which canbe observed in a certain area and the number of layers in these laminates, the number X of layers in total laminates and the number Y of layers in laminates dispersed in the form of a laminate of five layers or less among the total laminates were determined. Using these X and Y, a rate (%) of laminar silicate dispersed in the form of a laminate of five layers or less was derived from the following equation (4):

$$\text{Rate of laminar silicate dispersed in the form of a laminate}$$
$$\text{of five layers or less (\%) = (Y/X)} \times 100\ (4).$$

(5) Measurement of dispersion particle diameter in resin

A molded body in plate form having a thickness of 100 $\mu$m was observed under a magnification of 10000 times with a transmission electron microscope, and a longer side of an inorganic compound, which can be observed in a certain area, was measured.

(6) Measurement of water absorption

A rectangular test piece was prepared by cutting a molded body in plate form having a thickness of 100 $\mu$m into a size of 3 cm $\times$ 5 cm, and after drying the test piece at 150°C for 5 hours, its weight (W1) was weighed. Next, the test piece was immersed in water and left standing for 1 hour in boiled water of 100°C, and then it was taken out and its weight (W2) was weighed after wiping the test piece well with waste. Water absorption was determined by the following equation:

$$Water\ absorption\ (\%) = (W2-W1)/W1 \times 100.$$

(7) Checking of ability to maintain shape

A test sheet having a thickness of 1 mm was pressed for 1 minute at a pressure of 5 MPa with a die having a U-shaped groove in a flat press heated to 150°C and the die was released at a rate of 100 $\mu$m/s to form an inverted U-shaped portion. The moldability 1, 2 and 3 in Table 1 represent the results of evaluating the cases where H/Ds of the dimensions of the U-shaped groove of the above die are 100 $\mu$m/200 $\mu$m, 200 $\mu$m/400 $\mu$m and 400 $\mu$m/800 $\mu$m. This molded sample was left standing for 3 minutes in an oven of a temperature of the glass transition point or the melting point, a temperature lower than them by 10°C and a temperature lower than them 20 °C and cooled to room temperature, and then the ability to maintain a shape 1, 2 and 3 corresponding to the moldability 1, 2 and 3, respectively, was checked.

Denoting the ability to maintain a shape 1, 2 and 3 checked at a temperature of the melting point or the glass transition point of the resin by the ability to maintain a shape 1A, 2A and 3A, those checked at a temperature of the melting point or the glass transition point of the resin minus 10°C by the ability to maintain a shape 1B, 2B and 3B, and those checked at a temperature of the melting point or the glass transition point of the resin minus 20°C by the ability to maintain a shape 1C, 2C and 3C, each ability to maintain a shape was evaluated.

A dimensional ratio H/D of a pre-temperature raising molded sample was determined from a photograph obtained by photographing the molded sample in a slanting direction with a scanning electron microscope (SEM) and the moldability was rated based on this dimensional ratio. And, a dimensional ratio H/D of a post-temperature raising molded sample was similarly determined using a scanning electron microscope. The rate of maintaining a shape was determined from the ratio between dimensional ratio H/D values measured before and after temperature raising.

And, when a pre-molding vertical face $P_0$ is inclined after molding as shown in Figure 1, an angle $\theta$ which this inclined face forms with a horizontal plane was measured by a SEM. The case where $\theta$ is 80 to 90° angle is denoted by a symbol $\bigcirc$ and case where $\theta$ is less than 90° angle or a shape cannot be maintained is denoted by a symbol $\times$. These results are shown by a symbol on the right side of the measurements of the above rate of maintaining a shape determined from the ratio between dimensional ratio H/D values measured before and after temperature raising.

[Table 1]

| | Ex. 1 | Ex. 2 | Ex. 3 | Comp. Ex. 2 | Comp. Ex. 1 |
|---|---|---|---|---|---|
| Amount of Laminar Silicate Mixed with Respect to 100 Parts by Weight of Thermoplastic Resin (Parts by Weight) | 20 | 80 | 4 | 120 | 0 |
| Melting Point or Tg of Resin | 111 | 110 | 100 | 111 | 94 |
| CTE ($\alpha$1) [$\times$10E-6(1/°C)] | 34 | 29 | 55 | 28 | 84 |
| CTE ($\alpha$2) [$\times$10E-6(1/°C)] | 61 | 56 | 109 | 54 | 210 |
| Average Interlayer Distance (nm) | >3.5 | >3.5 | >3.5 | >3.5, 1.0 *Note | ND |
| Rate of Laminar Silicate of Five Layers or Less (%) | >10 | >10 | >10 | 8 | ND |
| Dispersion Particle Diameter in Resin ($\mu$m) | <0.5 | <0.5 | <0.5 | <0.5 | ND |
| Moldability 1 | ◎ | ○ | ◎ | × | ◎ |
| Moldability 2 | ◎ | ◎ | ◎ | ○ | ◎ |
| Moldability 3 | ◎ | ◎ | ◎ | ○ | ◎ |
| Ability to Maintain a Shape 1A | >95○ | >95○ | 760 | ND | <25 |
| Ability to Maintain a Shape 2A | >95○ | >95○ | 880 | 53× | <25 |
| Ability to Maintain a Shape 3A | >95○ | >95○ | 890 | 53× | <25 |
| Ability to Maintain a Shape 1B | >95○ | >95○ | 760 | ND | 30- |

(continued)

| | Ex. 1 | Ex. 2 | Ex. 3 | Comp. Ex. 2 | Comp. Ex. 1 |
|---|---|---|---|---|---|
| Ability to Maintain a Shape 2B | >95○ | >95○ | 880 | 72× | 30- |
| Ability to Maintain a Shape 3B | >95○ | >95○ | 890 | 72× | 30- |
| Ability to Maintain a Shape 1C | >95○ | >95○ | 760 | ND | 35- |
| Ability to Maintain a Shape 2C | >95○ | >95○ | 880 | >95○ | 35- |
| Ability to Maintain a Shape 3C | >95○ | >95○ | 890 | >95○ | 35- |
| Total Light Transmittance | 93.1 | 90.4 | 93.7 | 46.3 | 94.1 |

×10E-6 Represents $\times 10^{-6}$

\* Note: The interlayer distance of a laminate dispersed in the form of five layers or less was more than 3.5 and the interlayer distance of a laminate in the form of more than five layers was 1.

Symbols ○ and × on the right side of the values of the rate of maintaining a shape represent the evaluation of an angle θ from a horizontal plane. A symbol - (minus) means that the evaluation was not done because of poor H /D.

**Claims**

1. A thermoplastic resin composition containing 100 parts by weight of an amorphous thermoplastic resin and 0.1 to 100 parts by weight of an inorganic compound dispersed in said thermoplastic resin, **characterized in that** not less than 75% of the shape of a molded article is maintained at temperatures above the glass transition point of said thermoplastic resin.

2. A thermoplastic resin composition containing 100parts by weight of an crystalline thermoplastic resin and 0.1 to 100 parts by weight of an inorganic compound dispersed in said thermoplastic resin, **characterized in that** not less than 75% of the shape of a molded article is maintained at temperatures above the melting point of said thermoplastic resin.

3. The thermoplastic resin composition according to claim 1 or 2 , wherein the dispersion particle diameter of said inorganic compound is 2 μm or less.

4. The thermoplastic resin composition according to any one of claims 1 to 3, wherein said inorganic compound is an inorganic compound containing silicon and oxygen as a constituent element.

5. The thermoplastic resin composition according to any one of claims 1 to 4, wherein said inorganic compound is laminar silicate.

6. A material for substrates, **characterized in that** said material is composed by using the thermoplastic resin composition according to any one of claims 1 to 5.

7. A film for substrates, **characterized in that** said film is composed by using the thermoplastic resin composition according to any one of claims 1 to 5.

[FIG. 1]

$P_0$

$\theta°$

HORIZONTAL
PLANE

## INTERNATIONAL SEARCH REPORT

| | International application No. |
|---|---|
| | PCT/JP2004/018623 |

**A. CLASSIFICATION OF SUBJECT MATTER**
Int.Cl$^7$ C08L101/00, C08K3/00, C08K3/34, H05K1/03

According to International Patent Classification (IPC) or to both national classification and IPC

**B. FIELDS SEARCHED**

Minimum documentation searched (classification system followed by classification symbols)
Int.Cl$^7$ C08L101/00, C08K3/00, C08K3/34, H05K1/03

Documentation searched other than minimum documentation to the extent that such documents are included in the fields searched
| Jitsuyo Shinan Koho | 1926-1996 | Toroku Jitsuyo Shinan Koho | 1994-2004 |
| Kokai Jitsuyo Shinan Koho | 1971-2004 | Jitsuyo Shinan Toroku Koho | 1996-2004 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2003-26939 A (Sekisui Chemical Co., Ltd.), 29 January, 2003 (29.01.03), Claims; Par. Nos. [0014] to [0029], [0065] to [0090], [0112] to [0113], [0145] table 1, [0156] & WO 2002/46312 A1 & AU 200221097 A & EP 1350815 A1 & KR 2003064804 A & US 2004/53061 A1 & TW 559835 A & CN 1479768 A | 1-7 |
| X | JP 2003-313313 A (Sekisui Chemical Co., Ltd.), 06 November, 2003 (06.11.03), Claims; Par. Nos. [0009] to [0027], [0060] to [0087] (Family: none) | 1-5 |

| [X] Further documents are listed in the continuation of Box C. | | [ ] See patent family annex. |
|---|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 29 March, 2005 (29.03.05) | 19 April, 2005 (19.04.05) |

| Name and mailing address of the ISA/ | Authorized officer |
|---|---|
| Japanese Patent Office | |
| Facsimile No. | Telephone No. |

Form PCT/ISA/210 (second sheet) (January 2004)

**INTERNATIONAL SEARCH REPORT**

| International application No. |
|---|
| PCT/JP2004/018623 |

C (Continuation).  DOCUMENTS CONSIDERED TO BE RELEVANT

| Category* | Citation of document, with indication, where appropriate, of the relevant passages | Relevant to claim No. |
|---|---|---|
| A | JP 2002-338823 A (Mitsubishi Plastics, Inc.), 27 November, 2002 (27.11.02), Claims (Family: none) | 1-7 |
| A | JP 2002-15850 A (Mitsubishi Plastics, Inc.), 24 May, 2002 (24.05.02), Claims (Family: none) | 1-7 |
| A | JP 2002-151848 A (Sekisui Chemical Co., Ltd.), 24 May, 2002 (24.05.02), Claims (Family: none) | 1-7 |
| P,A | JP 2004-244510 A (Sekisui Chemical Co., Ltd.), 02 September, 2004 (02.09.04), Claims (Family: none) | 1-7 |
| P,A | JP 2004-149584 A (Fuji Photo Film Co., Ltd.), 27 May, 2004 (27.05.04), Claims (Family: none) | 1-7 |
| P,A | JP 2004-59918 A (Sekisui Chemical Co., Ltd.), 26 February, 2004 (26.02.04), Claims (Family: none) | 1-7 |

Form PCT/ISA/210 (continuation of second sheet) (January 2004)